# EUROPEAN PATENT SPECIFICATION

(11) **EP 0 776 991 B1**
(45) Date of publication and mention of the grant of the patent: **06.02.2002**
(21) Application number: 96308849.7
(22) Date of filing: 05.12.1996
(51) Int. Cl.: C23C 16/56, C23C 16/34

(54) **Plasma annealing of thin films**
Plasmatempern von Dünnschichten
Traitement thermique par plasma de couches minces

(30) Priority: 05.12.1995 US 567461
(43) Date of publication of application: 04.06.1997
(73) Proprietor: APPLIED MATERIALS, INC., Santa Clara, California 95054-3299 (US)
(72) Inventor: Danek, Michael, Curpertino, CA. 95015 (US); Englhardt, Eric, Palo Alto, CA. 94301 (US); Liao, Marvin, San Jose CA. 95129 (US); Mosely, Roderick C., Pleasanton. CA. 94588 (US); Chern, Chyi, Saratoga, CA. 95070 (US); Littau, Karl A., Palo Alto, CA. 94303 (US); Raajimakers, Ivo, Phoenix, Arizona 85048 (US)
(74) Representative: Bayliss, Geoffrey Cyril

(56) References cited:
- EP-A- 0 174 743
- EP-A- 0 446 988
- EP-A- 0 477 990
- EP-A- 0 711 846
- JP-A- 9 115 917
- US-A- 5 017 403
- PATENT ABSTRACTS OF JAPAN vol. 013, no. 026 (E-706), 20 January 1989 & JP 63 229814 A (NEC CORP), 26 September 1988,
- HAERTEREI TECHNISCHE MITTEILUNGEN, vol. 42, no. 3, May 1987, pages 153-160, XP002012760 RIE K -T ET AL: "ABSCHEIDUNG VON TITANNITRIDSCHICHTEN MITTELS PLASMA-CVD"

## Description

This invention relates to improving thin films formed on semiconductor wafers. More particularly, it relates to a method and apparatus to improve the characteristics of thin films in a semiconductor processing chamber by high density ion bombardment.

The manufacture of semiconductor devices involves depositing layers of various materials on a semiconductor wafer. This is typically done in a deposition chamber of a processing apparatus. Several methods of depositing layers of materials on the wafer exist, such as chemical vapor deposition (CVD), evaporation, epitaxy, and sputtering. Materials deposited may include silicon, silicon dioxide, aluminum, titanium, and titanium nitride.

As chip densities increase and semiconductor processes shrink, the quality of fabrication becomes more crucial. In particular, the composition, structure, and stability of deposited films must be carefully controlled to achieve the desired electrical characteristics and barrier quality. This can be illustrated by considerations relating to the formation of titanium nitride (TiN) thin films in semiconductor wafer processing.

Titanium nitride films are typically made by a CVD process, starting with a metallo-organic titanium compound such as Ti(NR₂)₄, or tetrakisdialkylamino titanium, wherein R is an alkyl group. For example, it is common to use tetrakisdimethylamino titanium (TDMAT), which has the formula Ti(N(CH₃)₂)₄. This compound readily decomposes to deposit titanium nitride at comparatively low temperatures of 200-600°C under vacuum pressures of about 0.1 to 100 Torr. Thus, TDMAT is suitable for thermal deposition of titanium nitride in a CVD chamber, where such temperatures and pressures are typical.

Alternatively, the titanium nitride film may be deposited by reacting the compound with a remotely generated reactive species, such as free radicals from ammonia, nitrogen, hydrogen, or hydrazine. The film may also be deposited in a plasma-enhanced CVD process (PECVD), wherein a plasma is used to drive the reaction and subsequent deposition. This process may be distinguished from the thermal CVD process in that PECVD uses the energy of charged particles from the plasma to initiate the reaction, while the thermal CVD process uses the elevated temperature of the substrate to initiate the reaction.

Titanium nitride films can also be formed by sputtering titanium metal in a nitrogen environment, forming titanium nitride on the substrate. In one embodiment of this process, a chamber containing upper and lower parallel plates is charged with a gas, such as argon. The upper of the two plates (the cathode) has a target consisting of titanium affixed to it, and is connected to a dc voltage source. The lower plate (the anode) supports the semiconductor wafer and is connected directly or through a capacitor to a radio frequency (rf) voltage source.

In operation, a negative potential is applied to the cathode. The anode becomes negatively biased due to the rf source and the capacitance of the wafer (and the capacitor, if used). The electric field between these two plates causes electrons to be emitted from the cathode, which strike atoms of argon in the region between the plates. Argon atoms lose their electrons and become positively ionized. These ions are attracted to the cathode by its negative bias, and strike the target. Atoms of titanium are dislodged from the target, or "sputtered," and travel across the plasma to strike the substrate. Some titanium atoms may themselves be ionized in the plasma. The sputtered titanium atoms or ions may stick to the surface or strike it with sufficient energy to become implanted deeper into the substrate. Some diffusion occurs, whereby the sputtered titanium spreads sideways or move deeper into the substrate.

In a development of this process, called reactive sputtering, a reactive gas is added to the usual argon sputtering plasma to alter the composition of the material deposited onto the substrate. For example, titanium nitride is reactively sputtered by adding nitrogen to the argon plasma gas. The nitrogen becomes ionized in the plasma and combines with the titanium atoms passing through the plasma to form titanium nitride.

Unfortunately, each of these methods of film deposition has certain disadvantages.

Thermal CVD deposition of titanium nitride films has the advantage of good deposition rates, good conformality and coverage of stepped features, low defect densities, and the resultant titanium nitride layer has good barrier properties. However, in some processes, such as those using TDMAT, the resistivity of the titanium nitride film is high and unstable. This is partly because a significant fraction of the deposited film is composed of carbon (hydrocarbons, carbides, etc) and because the titanium, a chemically reactive metal, may not be completely reacted in the film.

The high carbon content and unreacted titanium result in a chemically reactive film. When the film is exposed to air or other gas containing oxygen, oxygen is absorbed, impairing stability and increasing resistivity. After exposure to air, the resistivity of the TiN film can increase to about 10,000 µΩ-cm and sometimes to as high as 100.000 µΩ-cm. This is problematic when using the film as a barrier layer for conductive contacts and vias, where it is desirable to reduce resistivity to about 1000 µΩ-cm or less. Therefore, past usage of thermally deposited CVD titanium nitride in integrated circuit manufacturing has usually been limited to applications where the contribution of the titanium nitride film resistance to the overall resistance of the contact is marginal.

On the other hand, films deposited by sputtering in a physical vapor deposition (PVD) process typically have low resistivities in the range of 50 to 150 µΩ-cm. However, in a conventional PVD process, it is difficult to deposit layers that accurately conform to the topography of the substrate, which may include stepped surfaces defining wires, trenches, vias, contact holes, or other features.

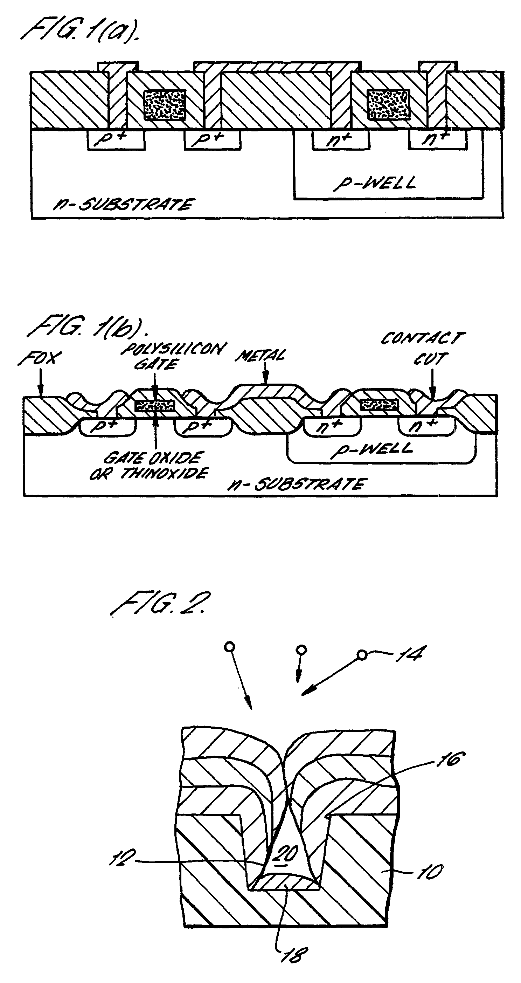

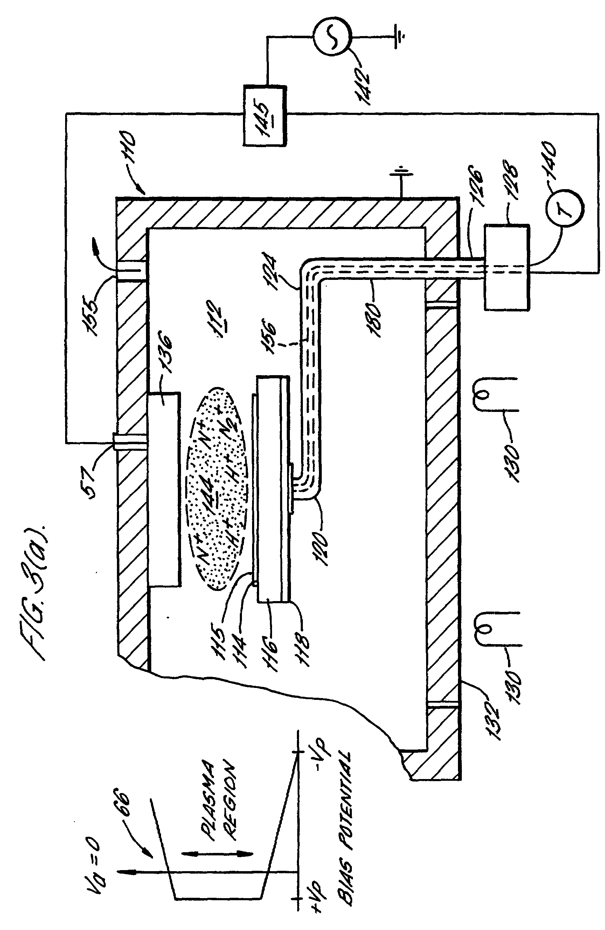

This problem is illustrated in FIGS. 1(a) and (b) which depict, respectively, an idealized and a more representative actual cross-section of an integrated circuit. As can be seen from FIG. 1(b), the features in the actual integrated circuit are not straight or planar. This causes the electrical characteristics of the actual integrated circuit to deviate from the design parameters, and may adversely affect the behavior of the circuit. For example, a careful design of a high speed integrated circuit would take into account the various parasitic capacitances present in the semiconductor structure. Deviations in the size and configuration of the features alter their capacitance in ways that may cause incorrect behavior of the circuit. It is thus necessary to design more conservatively and leave larger safety margins.

Furthermore, because of the stepped surface of the wafer, uneven deposition results. Buildup occurs at the outside corners of the trench. This build-up causes overhangs which close across the trench to form a void at its base. Also, where the spacing between the walls is small (less than, say, 1.6 microns), the deposited metal layer is thinner at the floor of the trench in the region between the walls.

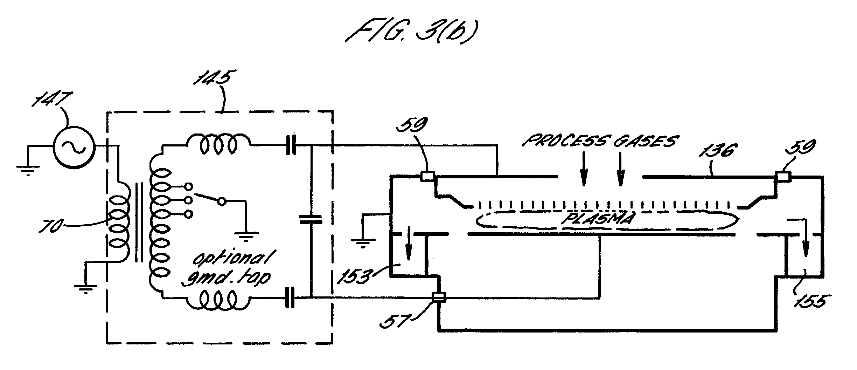

This problem is illustrated in FIG. 2. As shown, a semiconductor wafer 10 has a trench 12 formed in its surface during processing, prior to the deposition of a metal layer. The depositing atoms 14 from a typical PVD process, arrive at incident angles which are not perpendicular to the wafer 10, and tend to build up at the outside corners 16 of the trench. The problem worsens as the buildup continues and the deposited material "shadows" the interior of the trench. As a result, the trench is not filled completely, and instead, has a thin layer of metal 18 on its floor while its outside corners have an excessively thick layer of metal deposited on them. As deposition continues, the built-up corners "grow" toward each other and eventually close off the unfilled interior of the trench, resulting in the formation of a void 20 in the trench 12.

Additionally, plasma deposition processes, such as the PVD and plasma enhanced CVD (PECVD) processes, generate significantly higher levels of macroparticles than conventional CVD processes. Macroparticles, otherwise known as particulates, dust, or powder, are undesirable because they contaminate the device. For example, such particulate contaminants cause polycrystalline defects in epitaxial layers, electrical shorts between levels of integrated circuitry, and open circuits in wires. Among plasma deposition processes, plasma CVD has the largest potential for particle generation, because of homogeneous nucleation. Molecules of the precursor gas are activated by the plasma and may react with each other before reaching the substrate. Particle growth also increases rapidly with process pressure and plasma density. This is a signficant concern, since increased plasma densities are generally desirable for improving film characteristics through plasma bombardment.

Thus, neither the CVD nor PVD processes are entirely suitable in all applications. The need is, therefore, to achieve the high conformality and good fill performance of CVD while maintaining acceptable electromigration resistance and achieving the advantageous stable film characteristics of PVD.

EP-A-0,711,846 (Applied Materials, Inc., in the name of the inventors of the present application,) relates to a method for improving the properties of thin films and, in particular, to a method of densifying and stabilizing the resistivity of titanium nitride films.

JP-A-9-115,917 (Applied Materials, Inc., in the name of the inventors of the present application,) relates to a method for improving the properties of thin films deposited on semiconductor substrates and, in particular, to a method of densifying and stabilizing the resistivity of such films.

US-A-4,871,421 relates to the construction and operation of plasma etching systems and, in particular, to methods and apparatus for powering single wafer plasma etch systems including a pair or parallel opposed electrodes.

EP-A-0,477,990 (Applied Materials, Inc., in the name of the inventors of the present application,) relates to a method of enhancing the properties of a thin film on a substrate.

US-A-5,017,403 relates to a planarization process and apparatus which employs plasma-enhanced chemical vapor deposition (PECVD) to form planarization films of dielectric or conductive carbonaceous material on step-like substrates.

Accordingly, the present invention provides a method of treating a nitride film on a substrate, which method comprises the steps of:
(i) depositing a layer of a nitride material on the substrate;
(ii) exposing the layer to an environment containing ions by generating a plasma in the vicinity of the layer, wherein the layer defines a first plane on a first side of the plasma and a conductor defines a second plane parallel to and spaced from the first plane such that the plasma is generated between the first and second planes; and
(iii) applying RF power to bias the layer and the conductor, during the step of exposing, to cause ions from the environment to impact the layer to thereby improve the resistivity thereof, wherein the conductor is biased with an alternating electric field.

The density of the ion flux toward the substrate may be controlled independently of the energy with which the substrate is bombarded.

This is achieved as described herein. A substrate is placed on a substrate support in a CVD chamber. An rf source supplies rf power to the substrate support, causing the substrate to become negatively biased.
Above the substrate is a showerhead through which processing and plasma gases are introduced. This showerhead is connected to the first rf source through a matching network, or alternatively, to a second rf source. Under the influence of the rf power, a plasma containing positively charged gas ions is created above the substrate. The negative bias of the substrate causes the positively charged gas ions to be accelerated into the substrate, bombarding it and improving the characteristics of a film previously deposited on the substrate.

The apparatus allows the plasma density to be controlled independently of the substrate biasing. This is achieved by driving the showerhead with rf power as described above, which allows more rf power to be coupled into the plasma without increasing the negative bias at the substrate. This allows the creation of high ion densities and increased ion flux without necessarily increasing the energy of the ion flux, and thus, damage to the substrate from high-energy ion bombardment can be minimized. At the same time, the novel method of use allows for increasing the plasma density without incurring the penalty of higher particle growth rates, as would be the case in a deposition process using plasma. In addition, the plasma density is more uniform across the surface of the substrate.

Nitrogen may be used, alone or mixed with an inert gas, such as argon or helium for the plasma gas. Preferably, hydrogen or a hydrogen bearing gas, such as NH₃, is added to the plasma gas in a nitrogen to hydrogen ratio of 3:1, in order to reduce the level of carbon contaminants in the chamber and the deposited film.

To minimize resistivity and contaminants in the film, and optimize film quality, film deposition may be alternated with the ion bombardment process. Thus, a high quality film may be built up from successively deposited and "enhanced" sub-films.

Preferably, the deposition and enhancement processes are achieved in a single CVD chamber without removing the substrate. This minimizes downtime resulting from substrate transfer and reduces the potential for contamination during transfer.

The invention thus utilizes nitrogen-hydrogen or nitrogen-hydrogen-argon rf plasmas lo enhance CVD films by reducing its carbon content, enhancing its electrical conductivity, chemically stabilizing it, and improving its morphology and crystalline structure.

In the accompanying drawings,
FIG. 1(a) and 1(b) are sectional views showing idealized and representative cross-sections of a semiconductor device;
FIG. 2 is a sectional view showing deposition of a layer on a substrate having a trench;
FIG. 3(a) is a schematic illustration of a processing chamber illustrating the invention, with an accompanying graph indicating the potential at various points in the apparatus;
FIG. 3(b) is a schematic of the rf matching network connected to a processing chamber used to practice the invention:
FIG. 3(c) is a schematic of an alternate rf power configuration connected to a processing chamber used to practice the invention;
FIG. 4 is a longitudinal cross-section through the susceptor and its support arm from the chamber of FIG. 3(a);
FIG. 5 is a schematic pictorial representation showing connector details of the rf power strip located in the arm of FIG. 4:
FIG. 6(a) is an Auger electron spectroscopic depth profile for a titanium nitride film formed by successively depositing and annealing titanium nitride layers 100 angstroms thick on top of silicon dioxide, in accordance with the invention;
FIG. 6(b) is an Auger electron spectroscopic depth profile for a titanium nitride film formed by successively depositing and annealing titanium nitride layers 50 angstroms thick on top of silicon dioxide, in accordance with the invention;
FIG. 7 is an x-ray diffraction glancing angle scan of a prior art CVD titanium nitride layer, 1000 angstroms thick, deposited on a silicon wafer; and
FIG. 8 is an x-ray diffraction glancing angle scan of a CVD titanium nitride layer, 1000 angstroms thick, deposited on a silicon wafer and treated in accordance with the invention.

### DETAILED DESCRIPTION

### Overview

In overview, this invention is based on the use of pulsed bombardment with ions from a nitrogen-hydrogen plasma to bombard a substrate. This is used to reduce and stabilize the resistivities of, crystallize, and densify thin films deposited in a CVD process. The present invention thus provides a good fill performance, lower particle generation and low resistance films in a thermal CVD process.

### Apparatus

As the cycling of deposition and treatment can be achieved in a single chamber, the advantage of this is that the cycling can occur relatively rapidly, thereby minimizing the downtime required for wafer transfer between deposition and treatment chamber, as well as the particulate contamination that often attends wafer transfer.

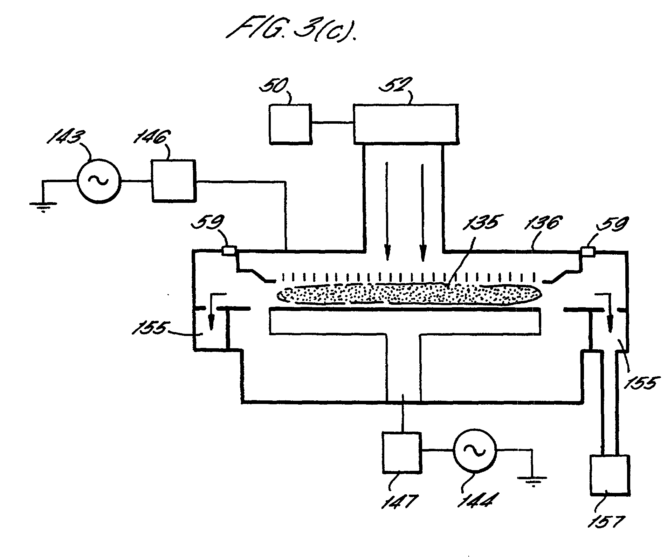

FIGS. 3(a), 3(b), 3(c), 4, and 5 illustrate, in greater detail, a deposition apparatus for CVD film deposition and plasma annealing according to the invention.

As shown in FIG. 3(a), a semiconductor wafer processing apparatus 110 includes a processing chamber 112, which is connected to ground. A semiconductor wafer 114 is supported in this chamber on an anodized aluminum susceptor 116 which in turn is supported by a conventional alumina ceramic support plate 118. The combination of support plate 118, susceptor 116 and wafer 114 is supported on the free end 120 of a cantilevered alumina support arm 122. The fixed end 124 of the support arm 122 is mounted to a generally vertically moveable stem 126 which in turn is vertically displaceable under action of a displacement mechanism 128. The chamber 112 and its contents are heated by means of conventional lamps 130 which irradiate the interior of the chamber 112 through a conventional quartz window 132. The apparatus 110 further includes a temperature determination means 140 which senses the temperature of the susceptor in a generally conventional manner.

In addition, a vacuum pump 157 is used to reduce the pressure within the chamber 112 to a base pressure compatible with high vacuum PVD systems, typically 10⁻⁵ to 10° Torr, in order to facilitate wafer transfer between the chamber 112 and PVD chambers (not shown). A showerhead 136 is placed above the susceptor 116 and electrically isolated from the chamber 112 by means of an isolator 159. The showerhead is supplied with processing and plasma fluids, generally in gaseous form, from a gas panel 52 which is controlled by a gas controller 50 in the form of a computer.

FIG. 3(b) shows a different configuration of the apparatus, and the use of isolators 59 to electrically isolate the showerhead 136 from the chamber 112. Similarly, isolator 57 electrically isolates the rf power connection from the chamber 112.

Referring back to FIG. 3(a), the gas panel controller 50 causes the gas panel 52 to supply CVD process gas to the showerhead 136 during CVD operations. The process gas, carrying a film forming precursor gas such as TDMAT, is introduced into the chamber 112 through the showerhead 136 and transported to the heated wafer 114. This results in the deposition of a thin film of material on the upper surface of the wafer 114. The carrier gas with the deposition by-products is exhausted from the chamber by means of the pump 157. During plasma annealing, a plasma gas, such as a combination of nitrogen, hydrogen, and argon as will be described below, is supplied to the showerhead 136 by the gas panel 52 under control of the gas panel computer 50.

Also provided is an rf source 142 for applying rf power to the susceptor 116 and the showerhead 136. The rf source 142 connects to the susceptor 116 and the showerhead 136 through matching network 145. This matching network 145 is a conventional resistor/inductor/capacitor network which is well-known in the art. In this configuration, the matching network 145 matches the load impedance to the source impedance in order to maximize the power delivered by the source at a given frequency, and splits rf power between the susceptor 116 and the showerhead 136.

Shortly after depositing the film onto the wafer 114, and preferably without removing the wafer from the chamber 112, the wafer is subjected to ion bombardment from a plasma. This is achieved by introducing an ionizable species, such as nitrogen (N₂) gas, into the chamber 112 through the showerhead 136. Hydrogen (H₂) gas, in a nitrogen to hydrogen ratio of 3:1, is also introduced. RF power is applied to the susceptor 116 and to the showerhead 136 to ionize the gas and form the plasma 135. As the rf source 142 cycles the voltage, electrons and ions periodically move in the plasma 135 in response to the changing potential. Because electrons are more mobile than ions, the repeated cycling of voltage from the rf signal eventually results in a surplus of electrons in the vicinity of the wafer 114. This produces a negative bias at the wafer. Thus, there are negative biases at both the wafer 114 and the showerhead 136 clue to the capacitances in the matching network 145. In operation, the susceptor 116 may acquire a negative bias of -100 to -400 volts, typically -300 volts, while the showerhead 136 acquires a negative bias of -100 to 400 volts, typically -200 volts. This is illustrated to the left of the chamber by a voltage graph 66 showing the potential across the chamber 112.

The plasma contains positively charged nitrogen and hydrogen ions, which are accelerated by this negative bias toward the wafer 114 to strike its surface. This bombardment by the ion flux from the plasma 135 results in densification and stabilization of the film of the wafer, and improves its resistivity and structure. The ion flux may be increased by changing the phases of the rf signals applied to the susceptor 116 and the showerhead 136, or increasing the rf power applied to the showerhead 136. This increases the density of the plasma, and because more ions are created, more ions are available to bombard the wafer 114 and enhance the properties of the film. Further DC bias at the wafer may be controlled independently of plasma density by changing the power split between the wafer support 54 and the inlet 56.

To further improve the thin film, deposition may be cycled with "plasma annealing" as described above. Thus, the film can be built up from successively deposited and plasma annealed sub-films.

A matching network used in an embodiment of the invention is illustrated in FIG. 3(b). In this figure, the matching network 145 is shown to comprise an isolation transformer 70, two inductors 80 and 82, and three capacitors 72, 74, and 76. The isolation transformer 70 may have a primary to secondary turns ratio ranging from 1:1 to 1:4, with 1:1.22 being typical. A typical inductance for the inductors 80 and 82 is 50 µH, and the capacitances of the capacitors 72 and 76 are typically 0.1 µF. The capacitance of the capacitor 74 is typically 0.15 µF. Optionally, the transformer 70 may have a ground tap 78 which allows variable ground tap positions to change the power ratio between the showerhead 136 and the susceptor 116.

This matching network 145 may be used to supply rf signals to the susceptor 116 and the showerhead 136 that have the same power and frequency, but are 180 degrees out of phase. This efficiently couples rf power into the plasma, with the ability to control the negative bias at the susceptor 116. The density of the plasma can be controlled by changing the phase shift between the rf signals supplied to the susceptor 116 and the showerhead 136, or by altering the rf power split. The split ratio and the phase shift between the rf signals supplied to the susceptor 116 and the showerhead 136 may be changed by modifying the splitting transformer ratio in the matching network 145. This may be accomplished by changing the fixed ratio of the transformer 70, using a transformer with selectable tap positions to change the ratio to a discrete value, or using a continuously variable transformer.

Embodiments of an rf split power configuration may be seen by reference to United States Patent No. 5,314,603, titled "Plasma Processing Apparatus Capable of Detecting and Regulating Actual RF Power at Electrode within Chamber" and issued to Sugiyama et at., or to United States Patent No. 4,871,421, titled "Split-Phase Driver for Plasma Etch System" and issued to Ogle et al.

In an alternative configuration, depicted in FIG. 3(c), the susceptor 116 and the showerhead 136 may be powered by two rf sources 143 and 144 through respective matching boxes 146 and 147. In this configuration, separate rf signals may be provided to the susceptor 116 and the showerhead 136 which may or may not have the same frequency, phase, and power. The rf signal from one source may be used to control the phase of the rf signal from the other source. Also shown is the use of a heater pedestal 149, which supports the wafer 114 and incorporates a resistive coil (not shown) for heating the wafer 114.

In a preferred embodiment of the invention, rf power is supplied in a split rf power configuration. The rf source supplies 200-750 watts of rf power, preferably 350 watts, at 100 kHz to 13.56 MHz, preferably 350 kHz, and a phase shift of 180 degrees between the rf signal supplied to the wafer support 54 and the inlet 56. Other phase shifts may also be used.

The split power configuration described is advantageous over a configuration in which only the susceptor 116 is driven by rf power, in that the plasma density can be increased without driving the susceptor 116 at very high voltages, and the plasma uniformity across the wafer 114 is improved significantly, typically by a factor of 5. The split power configuration is also superior to a configuration in which only a showerhead 136 is driven, because applying of power to the showerhead only results in heavy ion bombardment of the showerhead 136 and generation of particles. In addition, the plasma treatment of the wafer 114 is much less effective.

### Components

As may be expected, the details of various components within the processing apparatus 110 differ from their counterparts in conventional CVD processing chambers. This is primarily because a conventional CVD chamber cannot be used for generating a plasma.

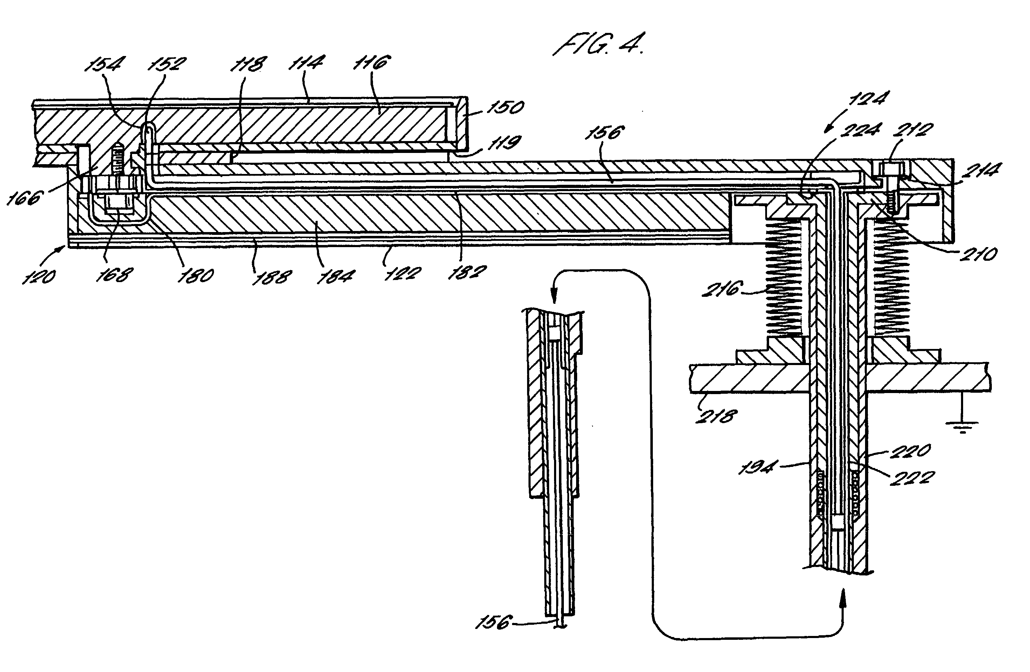

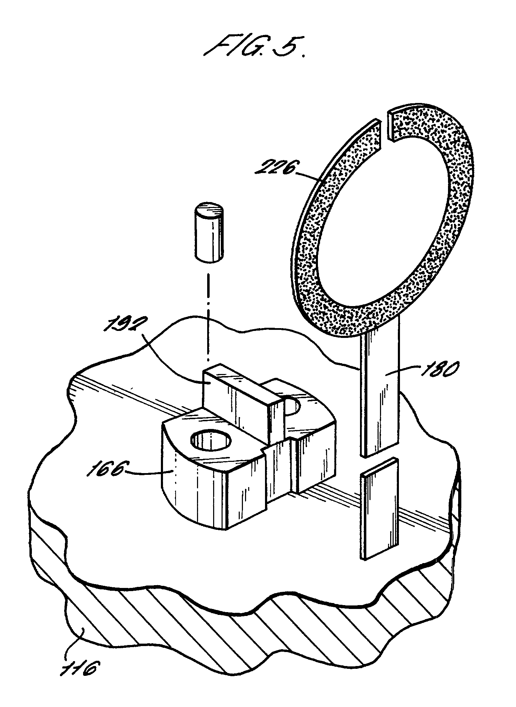

One of the most important modifications is in the wafer support arm 122, the details of which are described with reference to FIGS. 4 and 5. In FIG. 4, which is a longitudinal cross-section through the susceptor and the support arm it can be seen that a wafer 114 is supported on susceptor 116. The susceptor 116 is in turn supported by a conventional "Swiss Cheese" alumina ceramic support plate 118. A thin quartz plate 119 is located between the plate 118 and the susceptor 116. The quartz plate eliminates arcing between the susceptor and other components in the chamber. It is also transparent to radiant energy from the lamps 130. This allows the lamps 130 to quickly heat the susceptor 116. The susceptor 116 is encircled by a quartz shield 150, which rests on the alumina support plate 118 to extend above the susceptor and define a wafer receiving pocket within which both the susceptor 116 and the wafer 114 reside. As can be seen, the quartz shield 150 has its upper edge chamfered outwards to receive the wafer 114 more easily when it is transferred to and from the susceptor 116. The quartz shield 150 primarily functions to shield the edge of the susceptor 116 from arcing.

During processing, the temperature of the susceptor 116 is measured by means of the thermocouple 152 mounted in it. The thermocouple 152 is mounted within an aluminum nitride sheath 154 which snugly fits within the body of the susceptor 116 and provides electrical insulation between the thermocouple 152 and the body of the aluminum susceptor 116. Although the sheath 154 is electrically highly resistive, it remains a good conductor of heat. Because it has a low thermal mass and thus low thermal inertia, it is therefore suitable for use with the thermocouple 152. Furthermore, it is chemically stable within the processing environment of the chamber 112.

The thermocouple 152 is connected to the temperature sensor mechanism 140 by means of an electrically conductive cable 156. As will be described below, the thermocouple cable 156 passes along a central portion of the arm 120 and is electrically insulated from any radio frequency energy within the chamber 112. The thermocouple 152 is held in position by a small nickel sphere 158 which is crimped over the cable 156. The sphere 158 is retained in a slot 160 formed in a keyed ceramic retaining element 162. The keyed retaining element 162 keys into a groove 164 formed in a central protruding stub 166 on the underside of the susceptor 116. This arrangement ensures that the thermocouple can relatively easily be removed and replaced once the susceptor is separated from the support arm. Importantly, this arrangement also ensures that the thermocouple 152 is held firmly in place within the body of the susceptor 116 while remaining electrically isolated from the susceptor 116.

The susceptor is secured to the support arm 120 by means of a pair of bolts 168 which screw into the central stub 166. The arm 120 is primarily constituted by an inverted U-shaped ceramic section. The bolts 168 pass through holes passing through the horizontal portion of the U shaped section. To prevent excessive bearing of the bolts 168 onto the horizontal portion of the U- shaped section, each head is spaced from the horizontal portion by means of a Belvedere spring washer 174. Preventing excessive bearing of the head of the bolt 168 onto the ceramic U-shaped section is important as ceramic, particularly thin sectioned ceramic, is relatively brittle.

This figure also shows an rf conductive strip 180 passing along the arm 120 and electrically connected to the underside of the susceptor 116 at the stub 166. The rf conductor 180 is coated with a high temperature elastomeric dielectric material, known as polyamide, such as material sold by Dupont Electric under the trade name Pyralin.

This Pyralin coating electrically insulates the rf conductor 180. In addition, the rf conductive strip 180 is electrically isolated from the cable 156 by means of a ceramic isolator 182. Furthermore, the strip 180 is isolated from the interior of the chamber by the "legs" of the inverted U-shaped section and by a further isolator 184.

During assembly, the thermocouple 152 and its associated sheath 154 are inserted into the susceptor 116. The thermocouple's lead cable 156 is then fed into the U-shaped section. The susceptor 116 is fastened onto the U-shaped section by means of bolts 168, and the isolator 182 is placed over the rf strip 180 to isolate it from the cable 156. The strip 180 is then laid onto the isolator 182, after which the further isolator 184 is positioned over the rf strip 180. Thereafter, a flat ceramic retainer (not shown) is slotted into grooves 188 formed close to the free ends of the "legs" of the U-shaped section. This retainer acts as a retainer for all the various pieces which are located within the body of the U shaped section 170.

The fixed end 124 of the arm 120 is connected to the stem 194. The stem 194 is a hollow tube which flares at its upper end to define flanges 210 to which the fixed end 124 of the arm 122 is bolted by means of bolts 212. To prevent excessive bearing force between the bolts 212 and ceramic end 124, a Belvedere spring washer 214 is provided between each bolt 212 and the end 124. A stainless steel bellows 216 is positioned between the flange 210 and the lower wall 218 of the chamber 112. These bellows allow the arm 122 to be moved vertically up and down and, at the same time, provide a seal around the stem 194 as it passes through the wall 218 of the chamber 112.

As indicated previously, the stem 194 is in the form of a hollow tube. Inside this tube an electrically non-conductive tube 220 is located. It is typically made of a polyamide material and provides electrical isolation between the chamber 112 and a hollow, central rf conducting tube 222. This rf conducting tube 222 is connected to the rf source 142 and, as will be described below, to the rf conductive strip 180. The cable 156 communicating between the thermocouple 152 and the temperature determination means 140 passes down the central bore formed in the tube 222.

FIG. 5, when read with FIG. 4, illustrates how the connection is made between the conductive strip 180 and the tube 222. As is apparent from FIG. 4 the tube 222 flares at its upper end to define a circular flange 224. The strip 180, as illustrated in FIG. 5, ends in a circular conductive hoop 226. When the arm 122 is assembled, the hoop 226 is placed, as illustrated in FIG. 4, on the flange 224 of the rf conductive tube 222. This provides the necessary rf conductive connection to the strip 180 and to the susceptor 116. This connection allows for easy assembly and disassembly of the arm 122. It also allows for a certain amount of rotational freedom (about the longitudinal axis of stem 194) when the fixed end 124 of the arm 122 is being positioned onto the flange 210 of the stem 194.

The components represent only one of many different configurations that could be used. Similarly, the materials cited could also be different.

### Method of Use

By way of non-limiting example, the method of this invention and the use of this apparatus will be illustrated by the treatment of a CVD-deposited titanium nitride film to reduce its resistivity and improve its chemical stability. It will be readily apparent to one skilled in the art, however, that this invention is equally appropriate for treatment of other types of films, and to alter their compositions in other ways.

As a first step, a titanium nitride film is deposited on the wafer 114 using conventional CVD processing, and thereafter, subjected to ion bombardment without need for transfer to another chamber. Alternatively, the titanium nitride can be deposited on the wafer 114 in another chamber, and transferred into the chamber 112 for post-deposition plasma annealing.

For a standard 8 inch wafer process, the ion bombardment is achieved with a wafer 114 placed on the susceptor 116, and spaced at about 0.3 to 0.8 inches, preferably 0.6 to 0.7 inches, from the showerhead 136. The initially deposited titanium nitride layer may be 50-200 angstroms thick before the ion bombardment step. After the deposition process has ceased or, if deposition is carried out in a separate chamber, after the wafer 114 has been transferred into the chamber 112, a gas comprised of a 3:1 mixture of nitrogen and hydrogen is introduced into the chamber 112 via the showerhead 136 with a Nitrogen flow rate of about 300 sccm. The rf source 142 then supplies 350 watts of rf power at 350 kHz, through the matching network, to produce rf signals to the susceptor 116 and the showerhead 136 and which are 180 degrees out of phase.

Although the above describes a gas mixture having a nitrogen to hydrogen ratio of 3:1, any ratio between 3:1 and 1:2 may be used. Generally, a higher proportion of hydrogen in the mixture results in a film with greater long-term stability. However, it is speculated that too much hydrogen in the plasma results in bonding between hydrogen and carbon in the film to form polymers, which increase the resistivity.

A plasma containing positively charged nitrogen and hydrogen ions forms under the influence of the rf power supplied to the showerhead 136 and to the susceptor 116. The plasma is typically maintained for 10 to 30 seconds. As described above, the chamber 112 is at ground. The showerhead 136 acquires a negative bias of between - 100 to -400 volts, typically -200 volts. The wafer 114 self-biases to acquire a negative bias of between -100 to -400 volts, typically -300 volts. This negative bias voltage remains approximately constant during a bombardment period during which positively charged ions from the plasma are accelerated by the voltage gradient into the surface of the wafer 114. This causes the ions to bombard the wafer surface, penetrating to a depth of 50 to 100 angstroms. Energetic neutral atomic particles from the plasma may also bombard the wafer 114.

As a result of the ion bombardment, compression of the material occurs and the thickness may be reduced by 20-50% depending on the temperature of the substrate and the plasma treatment time and energy. Further layers, preferably 50 to 100 angstroms thick, may be successively deposited and annealed as desired.

### Modification of Reactive Materials Composition and Reduction of Resistivity in Titanium Nitride

As stated above, conventional thennal CVD processes provide good step coverage and generate less particulate contamination than PVD or PECVD processes, but have various disadvantages as well. These disadvantages are mostly overcome by this invention.

After ion bombardment as described above, the resulting annealed titanium nitride film exhibits many improved properties. Oxygen content is reduced from 20-25% down to less than 1%, and the density of the film increases from less than 3.1 grams per cubic centimeter (g/cm³) to about 3.9 g/cm³. The fraction of carbon incorporated in the film drops, from more than 25% to less than 3%. Changes in the structure of the film occur, and the resistivity drops from pre-treatment levels of, for example, 10,000 µΩ-cm to as low as 150 µΩ-cm. When later exposed to air, water vapor, or oxygen, oxygen is absorbed to a much lesser extent than with untreated titanium nitride.

The mechanism by which the ion bombardment alters the composition of the film is not known. It is believed that the activated species in the plasma, such as nitrogen and hydrogen ions, react with the atoms on the surface of the film. Additionally, the bombarding ions and energetic atoms strike the film with sufficient energy to penetrate, and may displace atoms from the lattices in the film, whereupon the displaced atoms are ejected from the film. In the case of titanium nitride films, carbon is incorporated into the film as titanium carbide and other carbon-containing compounds.

It is believed that when the film is treated with a nitrogen-hydrogen plasma in accordance with the invention, high energy plasma species, such as ions, bombard the titanium nitride film and react with the carbon present therein to form hydrocarbons, which diffuse from the film into the gas phase. Also, the bombarding nitrogen ions eject carbon atoms from the film, as well as becoming incorporated into the film. The hydrogen ions may also react with the ejected carbon atoms to form hydrocarbons. The volatile hydrocarbons are then exhausted from the chamber 112 by a vacuum pump. The carbon remaining in the film is in the form of conbide(?) which is relatively stable.

The net effect is that the proportion of titanium nitride present in the film is thus increased, while the proportions of carbon and oxygen are reduced. Furthermore, the addition of hydrogen to the plasma forming gas has been found to significantly reduce the amount of carbon, which was ejected from the film by the ion bombardment, that coats the inside of the processing chamber. This carbon coating has the detriment of changing the impedance of the chamber, thereby making precise control of the plasma difficult. The postulated reaction between the hydrogen and the carbon, to form hydrocarbons, appears to significantly reduce the carbon inside the chamber. This has a major advantage that the chamber can be used many more times between cleaning operations.

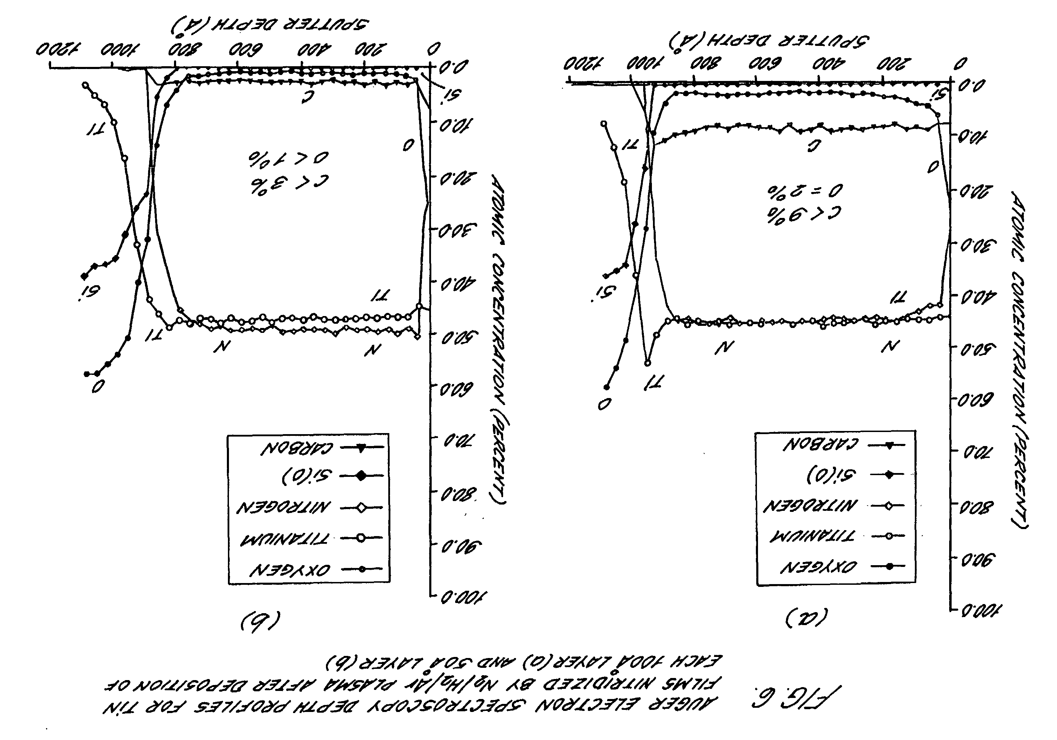

FIG. 6(a) is an Auger electron spectroscopic depth profile for a titanium nitride film formed by successively depositing and annealing titanium nitride layers 100 angstroms thick onto a silicon dioxide layer. As may be seen from the figure, the carbon and oxygen content are uniform throughout most of the film, at somewhat less than 9 atomic percent and at 2 atomic percent, respectively. The resistivity of this titanium nitride film was about 250 µΩ-cm.

Further improvements were obtained by depositing 50 angstrom layers, as shown in FIG. 6(b), which is an Auger electron spectroscopic depth profile for a titanium nitride film formed by successively depositing and annealing titanium nitride layers 50 angstroms thick on top of silicon dioxide. Again, the carbon and oxygen content are uniform throughout most of the film, at less than 3 atomic percent and 1 atomic percent, respectively. The proportions of titanium and nitrogen are higher than in the 100 angstrom process. Resistivity of this film was measured at 180 µΩ-cm.

The titanium nitride films thus treated in accordance with the invention are more stable, and have very low bulk resistivity, compared to CVD titanium nitride films previously produced. These films are also chemically stable in the presence of atmospheric oxygen, as indicated by the result of exposure to air for several days. The sheet resistivity increased by only about 2%, allowing the titanium nitride to be removed from the chamber and transferred to another chamber without needing to protect it from the atmosphere, and also improving the long-term stability of devices including the titanium nitride.

The present invention also produces films with very low defect densities. Titanium nitride films deposited and plasma annealed in accordance with the above process were produced on a batch of 2,000 silicon wafers. For defect sizes greater than 0.25 microns, the in-film defect density was approximately 0.06 cm⁻², compared to an in-film defect density of about 0.04 cm⁻² for defect sizes greater than 0.2 microns in non-plasma annealed CVD titanium nitride films.

The 2,000 wafer run also indicates the good repeatability of the process, as the standard deviation for the sheet resistivity of the 1,000 wafers was approximately 2.5%. It is believed that this is due to the presence of hydrogen in the plasma, which converts the carbon impurities into a volatile hydrocarbon species that is exhausted from the chamber. As indicated above, this reaction reduces the build-up of high impedance carbon deposits on the chamber which would affect the formation of the plasma.

It is envisioned that the composition of films composed of other materials may be altered in a similar manner using the present invention. Other gases may be added to the plasma in order to alter the chemical composition of the film, either by becoming incorporated into the film or reacting with the impurities present therein. For example, NH₃ and CH₄ may be used.

The titanium nitride films treated in accordance with the invention have excellent step conformality, typically in excess of 70% in 0.35 micron device structures with aspect ratios of about 4 to 5.

### Modification of Film Morphology

The present invention may be used to modify the morphology of films in an advantageous manner. Thin barrier materials may be subjected to the high density ion bombardment of the present invention in order to enhance the uniformity of their grain orientation. Because the orientation of grains in an underlying layer affects the structure of subsequently deposited layers, the present invention provides for the ability to modify and improve the morphology of sequentially deposited layers by modifying the crystal structure and/or growth orientation of the underlying layer.

It is possible to control the morphology of multiple layers by depositing a thin nucleation interface layer less than 50 angstroms thick, modifying it by high density ion bombardment, and then depositing the bulk or remaining film by standard techniques. The structure of the overlying layer would be determined by the structure of the underlying previously modified layer.

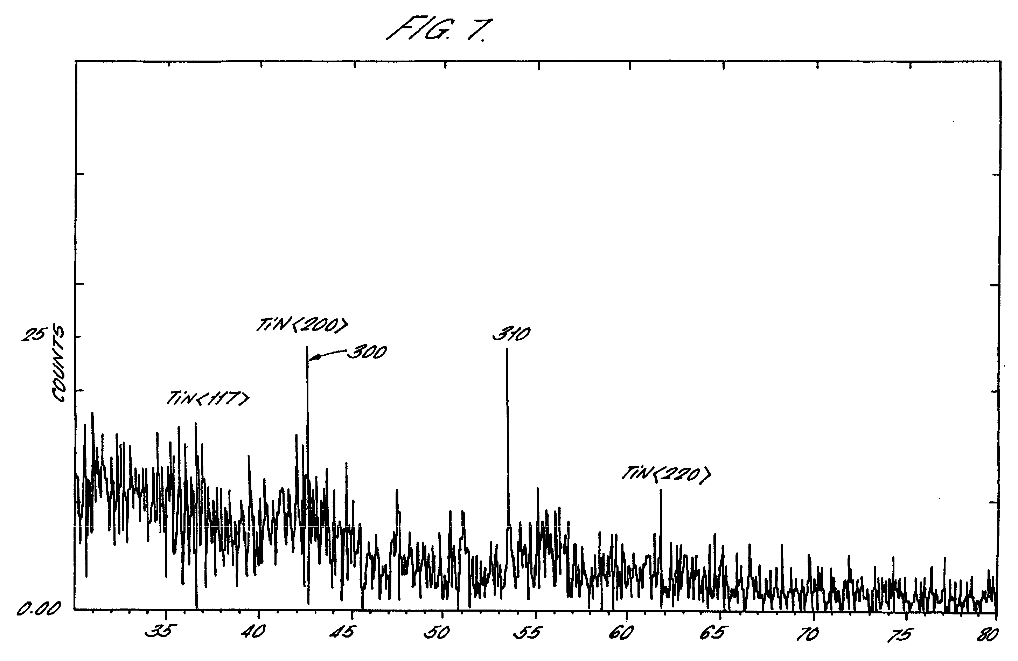

This can be illustrated with reference to FIG. 7. For titanium nitride films, it has been determined that the preferred crystalline orientation is <200>. It is speculated that the addition of hydrogen to the plasma may improve the film by making it more crystalline. FIG. 7 is an x-ray diffraction glancing angle scan of a prior art CVD titanium nitride layer, 1000 angstroms thick, deposited on a silicon wafer. The point on the curve indicating the number of grains oriented in the <200> direction is indicated by the label 300. As can be seen from the graph, there is no obvious TiN <200> peak. Tins is indicative of weak crystalline TiN <200> in films formed using prior art in CVD processes.

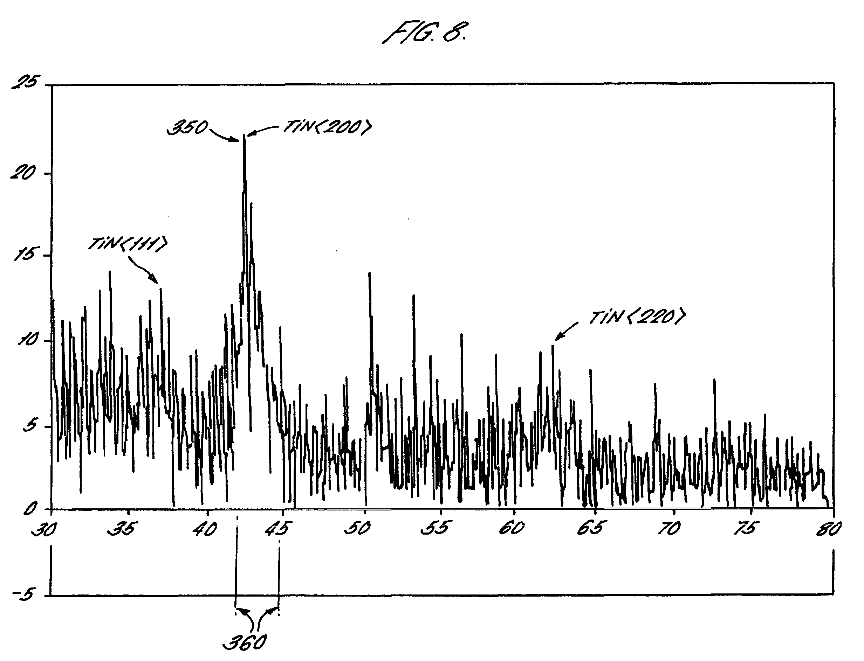

FIG. 8 is an x-ray diffraction glancing angle scan of a CVD titanium nitride layer, 1000 angstroms thick, deposited on a silicon wafer and treated in accordance with the invention. The diffraction pattern indicates that the film is microcrystalline with a preferred orientation (<200>) increased noticeably, as indicated by the label 360. There are more grains oriented in nearly the <200> direction, in the interval between 40 and 45 degrees. Additionally, the peak 310 in FIG. 7 is significantly lower in FIG. 8.

### Conclusion

While this invention has been described in terms of plasma annealing of CVD-deposited films, it will be obvious to one skilled in the art that this invention has applicability to PVD-deposited films. The present invention combines the advantages of the CVD processes with the advantages of PVD processes.

Although the present invention has been described above in terms of specific embodiments, it is anticipated that alterations and modifications thereof will no doubt become apparent to those skilled in the art. Additionally, although the invention has primarily been described for use in a thermal CVD chamber, the components and methods herein are equally suited for use in plasma deposition and other substrate processing operations.

## Claims

1. A method of treating a nitride film on a substrate, which method comprises the steps of:
(i) depositing a layer of a nitride material on the substrate;
(ii) exposing the layer to an environment containing ions by generating a plasma in the vicinity of the layer, wherein the layer defines a first plane on a first side of the plasma and a conductor defines a second plane parallel to and spaced from the first plane such that the plasma is generated between the first and second planes; and
(iii) applying RF power to bias the layer and the conductor, during the step of exposing, to cause ions from the environment to impact the layer to thereby improve the resistivity thereof, wherein the conductor is biased with an alternating electric field.

2. A method as claimed in claim 1, wherein the plasma contains ions of nitrogen, preferably ions of at least nitrogen and hydrogen, more preferably ions of at least nitrogen and hydrogen at a nitrogen to hydrogen ratio of 3:1.

3. A method as claimed in claim 2, wherein the plasma includes an inert gas, preferably argon or helium.

4. A method as claimed in any one of the preceding claims, wherein the steps of depositing, exposing and biasing are performed in a single processing chamber without removal of the substrate therefrom.

5. A method as claimed in any one of the preceding claims, wherein the step of depositing is performed using a chemical vapor deposition process.

6. A method as claimed in claim 5, wherein the film is deposited by thermal decomposition or chemical reaction of a metallo-organic compound.

7. A method as claimed in any one of the preceding claims, wherein the film is titanium nitride.

8. A method as claimed in any one of the preceding claims, wherein the depositing step deposits a layer having a thickness less than the thickness of the film and the steps of depositing and exposing are repeatedly cycled to define the film.

9. A method as claimed in any one of the preceding claims, wherein the layer and the conductor are respectively biased in cycles 180 degrees out of phase.

## Patentansprüche

1. Verfahren zum Behandeln eines Nitridfilms auf einem Substrat, wobei das Verfahren die Schritte aufweist
i) Abscheiden einer Schicht eines Nitridmaterials auf einem Substrat,
ii) Aussetzen der Schicht einer Umgebung, die lonen enthält, indem in der Nähe von jeder Schicht ein Plasma erzeugt wird, wobei die Schicht eine erste Ebene auf einer ersten Seite des Plasmas und ein Leiter eine zweite Ebene bildet, die parallel zu der ersten Ebene dazu so beabstandet ist, dass das Plasma zwischen der ersten und zweiten Ebene erzeugt wird, und
iii) Anlegen einer HF-Leistung zum Vorspannen der Schicht und des Leiters während des Aussetz-Schritts, um lonen aus der Umgebung zu veranlassen, auf die Schicht aufzuschlagen, um dadurch die Widerstandsfähigkeit zu verbessern, wobei der Leiter mit einem elektrischen Wechselfeld vorgespannt ist.

2. Verfahren nach Anspruch 1, bei welchem das Plasma Stickstoffionen, vorzugsweise lonen von wenigstens Stickstoff und Wasserstoff und besonders bevorzugt lonen von wenigstens Stickstoff und Wasserstoff in einem Stickstoff-zu-Wasserstoff-Verhältnis von 3:1 enthält.

3. Verfahren nach Anspruch 2, bei welchem das Plasma ein Inertgas, vorzugsweise Argon oder Helium enthält.

4. Verfahren nach einem der vorhergehenden Ansprüche, bei welchem die Schritte des Abscheidens, des Aussetzens und des Vorspannens in einer einzigen Behandlungskammer durchgeführt werden, ohne das Substrat daraus zu entfernen.

5. Verfahren nach einem der vorhergehenden Ansprüche, bei welchem der Schritt des Abscheidens unter Verwendung eines chemischen Dampfabscheideverfahrens ausgeführt wird.

6. Verfahren nach Anspruch 5, bei welchem der Film durch thermische Zersetzung oder chemische Reaktion einer metallorganischen Verbindung abgeschieden wird.

7. Verfahren nach einem der vorhergehenden Ansprüche, bei welchem der Film ein Titannitrid ist.

8. Verfahren nach einem der vorhergehenden Ansprüche, bei welchem bei dem Abscheideschritt eine Schicht mit einer Dicke abgeschieden wird, die kleiner ist als die Dicke des Films, und wobei die Schritte des Abscheidens und Aussetzens zur Bildung des Films im Zyklus wiederholt werden.

9. Verfahren nach einem der vorhergehenden Ansprüche, bei welchem die Schicht und der Leiter jeweils in Zyklen 180° außer Phase vorgespannt werden.

## Revendications

1. Procédé de traitement d'un film de nitrure sur un substrat, lequel procédé comprend les étapes dans lesquelles :
(i) on dépose une couche de matière comprenant un nitrure sur le substrat ;
(ii) on expose la couche à un environnement contenant des ions par génération d'un plasma au voisinage de la couche, la couche définissant un premier plan sur un premier côté du plasma et un conducteur définissant un second plan parallèle au premier plan et espacé de celui-ci afin que le plasma soit généré entre les premier et second plans ; et
(iii) on applique de l'énergie RF pour polariser la couche et le conducteur, pendant l'étape d'exposition, afin de provoquer un impact d'ions depuis l'environnement sur la couche pour améliorer ainsi sa résistivité, le conducteur étant polarisé avec un champ électrique alternatif.

2. Procédé selon la revendication 1, dans lequel le plasma contient des ions azote, avantageusement au moins des ions azote et hydrogène, plus avantageusement au moins des ions azote et hydrogène dans un rapport de l'azote à l'hydrogène de 3:1.

3. Procédé selon la revendication 2, dans lequel le plasma comprend un gaz inerte, avantageusement de l'argon ou de l'hélium.

4. Procédé selon l'une quelconque des revendications précédentes, dans lequel les étapes de dépôt, d'exposition et de polarisation sont effectuées dans une chambre de traitement unique sans que le substrat en soit enlevé.

5. Procédé selon l'une quelconque des revendications précédentes, dans lequel l'étape de dépôt est effectuée en utilisant un processus de dépôt chimique en phase vapeur.

6. Procédé selon la revendication 5, dans lequel le film est déposé par décomposition thermique ou par réaction chimique d'un composé organométallique.

7. Procédé selon l'une quelconque des revendications précédentes, dans lequel le film est en nitrure de titane.

8. Procédé selon l'une quelconque des revendications précédentes, dans lequel l'étape de dépôt dépose une couche ayant une épaisseur inférieure à l'épaisseur du film et les étapes de dépôt et d'exposition sont répétées périodiquement pour définir le film.

9. Procédé selon l'une quelconque des revendications précédentes, dans lequel la couche et le conducteur sont polarisés, respectivement, en des cycles déphasés de 180 degrés.
